# EUROPEAN PATENT APPLICATION

(11) **EP 3 954 795 A1**
(43) Date of publication of application: **16.02.2022**
(21) Application number: 20787755.6
(22) Date of filing: 02.04.2020
(51) Int. Cl.: C22C 5/08, C22C 9/00, H01L 23/15, B23K 35/30, H05K 1/09

(54) **CERAMIC COPPER CIRCUIT BOARD AND SEMICONDUCTOR DEVICE USING SAME**

(30) Priority: 11.04.2019 JP 2019075789
(71) Applicant: KABUSHIKI KAISHA TOSHIBA, Minato-ku Tokyo 105-0023 (JP); Toshiba Materials Co., Ltd., Isogo-Ku Yokohama-Shi Kanagawa 235-0032 (JP)
(72) Inventor: NABA, Takayuki, Yokohama-shi, Kanagawa 235-0032 (JP); KATO, Hiromasa, Yokohama-shi, Kanagawa 235-0032 (JP); YANO, Keiichi, Yokohama-shi, Kanagawa 235-0032 (JP)
(74) Representative: Henkel & Partner mbB
(86) International application number: PCT/JP2020/015211
(87) International publication number: WO 2020/209175

(57) **Abstract**

A ceramic copper circuit board (1) including a ceramic substrate (2), and a copper circuit part (3) located on the ceramic substrate (2), wherein an arbitrary line parallel to a first direction at a cross section of the copper circuit part (3) parallel to the first direction crosses multiple copper crystal grains (10), the first direction is from the ceramic substrate (2) toward the copper circuit part (3), an average of multiple distances in a second direction between the line and edges of the copper crystal grains (10) is not more than 300 µm, and the second direction is perpendicular to the first direction.

## Description

### [Technical Field]

An embodiment generally relates to a ceramic copper circuit board and a semiconductor device using the same.

### [Background Art]

A ceramic copper circuit board is used in a semiconductor device in which a semiconductor element such as a power element or the like is mounted. The ceramic substrate and the copper circuit part are bonded to each other via a bonding layer. The bonding layer includes a silver (Ag) brazing material that includes an active metal such as titanium (Ti) or the like. The bonding strength and the heat cycle characteristics are improved thereby. Due to the increase of the reliability, ceramic copper circuit boards are used in inverters of automobiles (including electric vehicles), electric railway vehicles, solar power generation equipment, industrial machinery, etc.

In a semiconductor device such as a power module or the like, a semiconductor element is mounted on the copper circuit part. Also, wire bonding and/or the bonding of a metal terminal also may be performed for the conduction of the semiconductor element. The semiconductor element, the wire bonding, the metal terminal, etc., are bonded to the copper circuit part in the manufacture of the semiconductor device.

With advances in downsizing, weight reduction, and higher-density mounting of power modules, the copper circuit parts are becoming thicker to reduce thermal resistance and reduce inductance. A ceramic copper circuit board that includes a thick copper circuit part is described in International Publication WO2018-180965 (Patent Literature 1). Patent Literature 1 improves the ease of assembly of the ceramic copper circuit board by optimizing the number of grain boundaries of the surface of a copper circuit board. According to the ceramic copper circuit board of Patent Literature 1, the bondability and the alignment precision of the semiconductor element are increased.

### [Prior Art Documents]

### [Patent Literature]

[Patent Literature 1]
International Publication No. 2018-180965

### [Summary of Invention]

### [Technical Problem]

On the other hand, other than the bondability or the alignment precision described above, problems that occur due to the copper circuit part being thick have become apparent. For example, to increase the reliability of the product, it is desirable to realize finer patterns of the copper circuit portion, stress relaxation of the overall circuit board, etc. The main focus of Patent Literature 1 is to control the grain size of the surface of the copper circuit part; however, it was found that by making the copper circuit thick, a grain size difference occurs between the surface and the interior. In other words, if the surface of the copper circuit is controlled, it is possible to increase the bondability and/or the alignment precision of the copper plate surface; however, it was found that to improve other characteristics such as a finer pattern, etc., it is necessary to control the copper circuit interior.

In recent years, the downsizing·weight reduction·higher-density mounting of power semiconductor modules are advancing. Accordingly, it is desirable to make the metal circuit part thick to reduce the thermal resistance of the metal circuit part and reduce the inductance of the metal circuit part. Also, a finer pattern of the metal circuit part is desirable to increase the mounting density.

Also, it is desirable to increase the reliability of the ceramic circuit board as the junction temperature (Tj) of the power semiconductor chip increases.

An embodiment is directed to solve such problems, and relates to a ceramic copper circuit board in which the circuit can be finer and the reliability of the ceramic circuit board can be increased.

### [Solution to Problem]

A ceramic copper circuit board (1) according to an embodiment includes a ceramic substrate (2) and a copper circuit part (3). The copper circuit part (3) is located at a first surface of the ceramic substrate (2). An arbitrary line parallel to a first direction at a cross section of the copper circuit part (3) parallel to the first direction crosses multiple copper crystal grains (10); and the first direction is from the ceramic substrate (2) toward the copper circuit part (3). An average of multiple distances in a second direction between the line and edges of the copper crystal grains (10) is not more than 300 µm; and the second direction is perpendicular to the first direction.

### [Brief Description of Drawings]

[FIG. 1]

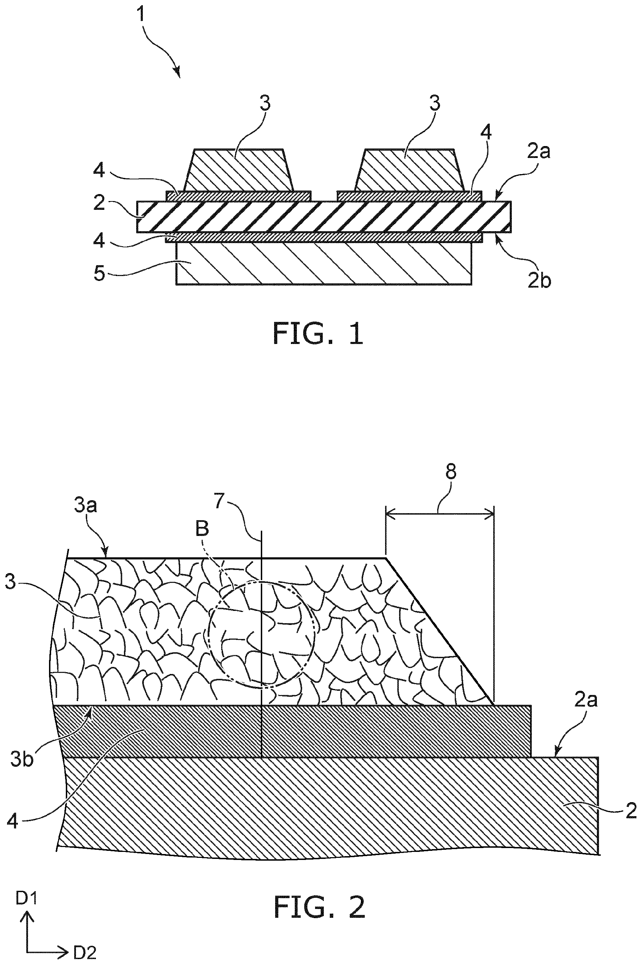

   FIG. 1 is a drawing showing an example of a ceramic copper circuit board according to an embodiment.
[FIG. 2]
   FIG. 2 is a drawing showing an example of a cross section of a copper circuit part.
[FIG. 3]

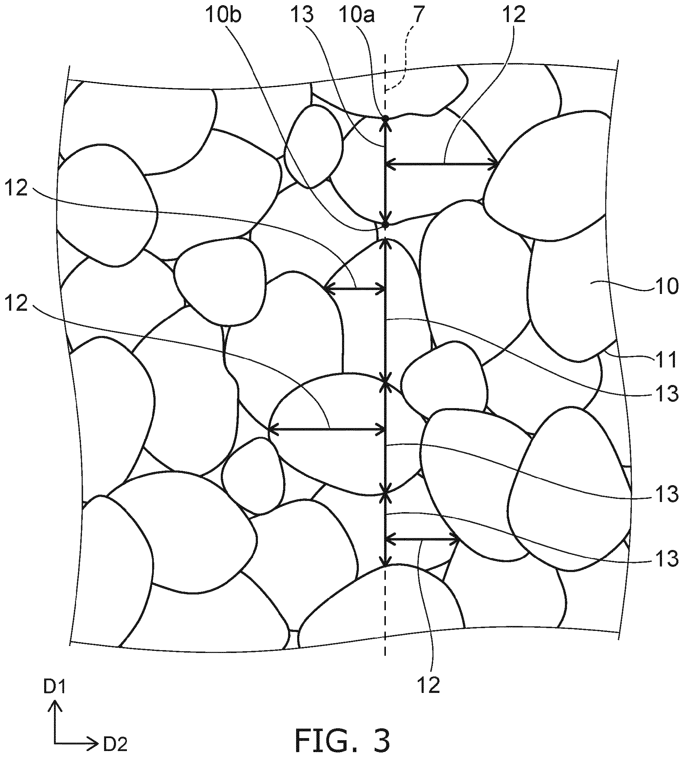

   FIG. 3 is a drawing showing an example of the cross section of the copper circuit part.
[FIG. 4]

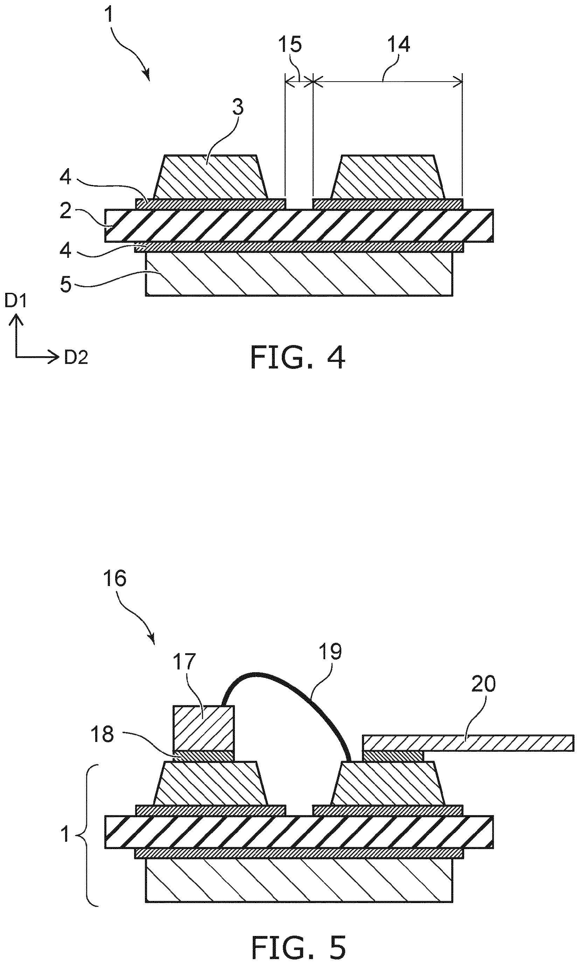

   FIG. 4 is a drawing showing an example of a pattern dimension and an inter-pattern dimension of a copper circuit.
[FIG. 5]
   FIG. 5 is a drawing showing an example of a semiconductor device according to an embodiment.

### [Description of Embodiments]

A ceramic copper circuit board according to an embodiment includes a ceramic substrate and a copper circuit part. The copper circuit part is located at a first surface of the ceramic substrate. An arbitrary line parallel to a first direction at a cross section of the copper circuit part parallel to the first direction crosses multiple copper crystal grains; and the first direction is from the ceramic substrate toward the copper circuit part. An average of multiple distances in a second direction between the line and edges of the copper crystal grains is not more than 300 µm; and the second direction is perpendicular to the first direction.

FIG. 1 shows an example of the ceramic copper circuit board. In FIG. 1, 1 is a ceramic copper circuit board. 2 is a ceramic substrate. 3 is a copper circuit part. 4 is a bonding layer that includes a brazing material. 5 is a back copper plate. The ceramic substrate 2 includes a front surface 2a (a first surface) and a back surface 2b. The copper circuit part 3 is bonded to the front surface 2a of the ceramic substrate 2 via a bonding layer 4 (an example of a first bonding layer). In the example of FIG. 1, multiple copper circuit parts 3 are bonded respectively to the front surface 2a via multiple bonding layers 4. The embodiment is not limited to the illustrated form. One copper circuit part 3, three copper circuit parts 3, or more may be bonded to the front surface 2a. Also, in the example of FIG. 1, the back copper plate 5 is bonded to the back surface 2b. The back copper plate 5 functions not as a circuit but as a heat dissipation plate. The back copper plate 5 is provided as appropriate and as necessary. Instead of the back copper plate 5, a patternized copper circuit part may be provided at the back surface 2b.

It is favorable for the ceramic substrate 2 to be at least one type of an aluminum oxide substrate, an aluminum nitride substrate, or a silicon nitride substrate. An Alusil substrate also is another example. Alusil is a sintered body in which 20 to 80% is aluminum oxide, and the remainder is zirconium oxide.

The three-point bending strength of an aluminum nitride substrate or an aluminum oxide substrate is about 300 to 450 MPa. The strength of an Alusil substrate also is about 550 MPa.

The three-point bending strength of a silicon nitride substrate is not less than 600 MPa, and can be further increased to be not less than 700 MPa. Also, the thermal conductivity of a silicon nitride substrate is not less than 50 W/(m·K), and can be further increased to be not less than 80 W/(m·K). In particular, in recent years, there is also a silicon nitride substrate that has both high strength and high thermal conductivity. It is favorable for the thickness of the silicon nitride substrate to be not more than 0.635 mm, and more favorably not more than 0.3 mm. Because the silicon nitride substrate has a high strength, the silicon nitride substrate can be thin; and it is possible to further improve the heat dissipation. Although the lower limit of the thickness is not particularly set, it is favorable to be not less than 0.1 mm. This is to ensure the electrical insulative properties of the silicon nitride substrate. Here, the thickness refers to the dimension in a direction connecting the ceramic substrate 2 and the copper circuit part 3.

The ceramic copper circuit board according to the embodiment may include one ceramic substrate or may include two or more ceramic substrates. For example, multiple ceramic substrates and multiple copper circuit parts may be alternately stacked in the first direction.

FIG. 2 is a drawing showing an example of a cross section of the copper circuit part. FIG. 2 is an enlarged cross-sectional view of portion A of FIG. 1. In FIG. 2, 7 shows an arbitrary virtual line. The line is parallel to the first direction that is from the ceramic substrate 2 toward the copper circuit part 3. In FIG. 2, D1 is the first direction. Also, the line is perpendicular to the front surface 2a and the back surface 2b. 8 is a side etching amount. The side etching amount is the distance in one direction perpendicular to the first direction between the outer perimeter of a front surface 3a of the copper circuit part and the outer perimeter of a back surface 3b of the copper circuit part.

The copper circuit part is made of a polycrystal of copper. The method of drawing the line 7 is as follows. First, the ceramic copper circuit board is cut parallel to the first direction D1. An enlarged photograph of the cross section is imaged. At this time, the enlarged photograph is imaged to be enlarged so that the ceramic substrate is visible and grain boundaries can be confirmed. Then, the line 7 is obtained by drawing an arbitrary straight line perpendicular to the front surface 2a in the enlarged photograph. Also, when the state of the front surface 2a of the ceramic substrate surface is indistinct and the back surface 3b of the copper circuit part 3 can be considered to be a surface that is parallel to the front surface 2a, an arbitrary straight line perpendicular to the back surface 3b may be treated as the line 7.

FIG. 3 shows an example of a cross-sectional view of the copper circuit part interior. FIG. 3 enlarges a cross section of portion B of FIG. 2. 10 is a copper crystal grain; and 11 is a grain boundary of the copper crystal grain. An arbitrary line 7 is drawn in a direction perpendicular to the ceramic substrate surface (the thickness direction of the substrate) at the cross section of the copper circuit part. In FIG. 3, 12 is a distance LH in a second direction D2 to the outer edge (a grain boundary 11) of the copper crystal grain 10 that is most distant to the arbitrary line 7 among the copper crystal grains 10 crossed by the line 7. 13 is a length LV between a first edge 10a and a second edge 10b at intersections between the line 7 and the outer edge of the copper crystal grain 10. The second direction is perpendicular to the first direction and parallel to the cross section.

In the ceramic copper circuit board according to the embodiment, the average of the distances LH is not more than 300 µm. It is favorable for the average of the lengths LV to be not more than 300 µm.

In a ceramic copper circuit board that includes a ceramic substrate and a copper circuit part bonded to the ceramic substrate, it is common to form a circuit by etching the copper plate portion after bonding a copper plate to the entire surface or a portion of the ceramic substrate. When the copper plate is dissolved by etching, the dissolution proceeds along the crystal grain boundaries of the copper plate. Therefore, the shape of the copper crystal grain greatly affects the etching. In other words, when the crystal grain size is large, the dissolution easily proceeds not only in the thickness direction in which the etchant carves but also in the planar direction. The planar direction is a direction perpendicular to the first direction. The second direction is one direction parallel to the planar direction.

The average of the distances LH being not more than 300 µm for multiple copper crystal grains crossing the line parallel to the first direction means that copper crystal grains that have relatively small dimensions in the second direction are arranged in the thickness direction. The progress of the etching in the planar direction can be suppressed thereby; and the side etching amount due to the etching can be reduced. As a result, a fine pattern circuit is easily formed.

Here, a fine pattern circuit refers to a circuit board in which the inter-pattern dimension is about 60 to 80% of that of a normal circuit. Also, a circuit of which at least a portion of the circuit satisfies inter-pattern dimensions in this range is a fine pattern circuit. FIG. 4 shows a pattern dimension 14 and an inter-pattern dimension 15 of the ceramic copper circuit board 1. The pattern dimension 14 shows the width of an electrical conduction portion that includes the bonding layer 4. The inter-pattern dimension 15 shows the dimension distance between the bonding layers 4 formed at the ceramic surface. In the example of FIG. 4, multiple copper plates 3 are bonded to the front surface 2a of the ceramic substrate 2. The multiple copper plates 3 are arranged with each other in the second direction D2 and are respectively bonded to the ceramic substrate 2 via the multiple bonding layers 4. The distance in the second direction D2 between the bonding layers 4 that are adjacent to each other in the second direction D2 corresponds to the inter-pattern dimension 15.

It is desirable for the width (the pattern dimension) of the pattern to be not less than a prescribed value for the conduction of electricity, the bonding of the semiconductor element and/or the metal terminal, wire bonding, etc. For example, when the copper plate thickness is not less than 0.1 mm but less than 0.5 mm, it is favorable for the pattern dimension to be not less than 0.5 mm. When the copper plate thickness is not less than 0.5 mm but less than 0.7 mm, it is favorable for the pattern dimension to be not less than 0.7 mm. When the copper plate thickness is not less than 0.7 mm but less than 0.8 mm, it is favorable for the pattern dimension to be not less than 1.0 mm.

Here, when the copper plate thickness is not less than 0.1 mm but less than 0.5 mm, the inter-pattern dimension is not less than 0.6 mm in a normal copper circuit board. Conversely, in a fine pattern circuit, the inter-pattern dimension is not less than 0.4 mm. Similarly, when the copper plate thickness is not less than 0.5 mm but less than 0.7 mm, the inter-pattern dimension is not less than 1.0 mm in a normal copper circuit board. Conversely, in a fine pattern circuit, the inter-pattern dimension is not less than 0.6 mm. When the copper plate thickness is not less than 0.7 mm but less than 0.8 mm, the inter-pattern dimension is not less than 1.8 mm in a normal copper circuit board. Conversely, in a fine pattern circuit, the inter-pattern dimension is not less than 1.1 mm.

Also, by setting the average of the lengths LV of the copper circuit part to be not more than 300 µm, the copper plate plastically deforms more easily. Thereby, the stress that is generated in the ceramic copper circuit board that is a bonded body can be relaxed, the bonding strength, the substrate bending strength, and the heat cycle resistance can be improved, and a highly-reliable ceramic circuit board can be obtained.

Also, in the ceramic copper circuit board, the grain size of the copper plate is increased by the heat treatment when bonding. Although it is also possible to use an additive to copper that controls the coarsening of the grains and/or to control the coarsening of the grain size by adjusting the patterning and bonding conditions, there is a possibility that the manufacturing cost may be increased by the control. For example, by setting the distance LH and the length LV to be not less than 50 µm, a ceramic copper circuit board that has good cost performance can be obtained. However, it is possible to manufacture using a smaller distance LH and a smaller length LV; and the lower limits are not regulated.

A semiconductor element or the like is bonded to the copper circuit part 3. To reduce the thermal resistance and reduce the inductance, it is favorable for the thickness of the copper circuit part to be not less than 0.5 mm, and more favorably not less than 0.8 mm. In such a case, the side etching amount is suppressed when the average of the distances LH of the copper circuit part interior is small. Thereby, it is possible to form a fine pattern. Also, the bonding strength, the substrate bending strength, and the heat cycle resistance are improved by relaxing the stress of the bonded body.

When the average of the distances LH of the copper circuit part interior is greater than 300 µm, the copper crystal grains of the copper circuit part interior become larger in the lateral direction; the side etching amount increases. Therefore, the dimensional precision of the circuit pattern decreases.

When the average of the lengths LV of the copper circuit part interior is greater than 300 µm, the plastic deformation of the copper circuit part is reduced. As a result, the stress of the bonded body increases, and characteristics such as the bonding strength, etc., degrade more easily.

Also, when each of the distances LH and each of the lengths LV are adjusted to be less than 50 µm, the manufacturing cost increases due to the load due to the process control.

Also, even when the average of the distances LH is not more than 300 µm, fluctuation of the side etching amount occurs when many copper crystal grains of which the distance LH is greater than 400 µm exist. It is favorable for the distance LH to be not more than 400 µm. Similarly, even when the average of the lengths LV is not more than 300 µm, fluctuation of the bonding strength occurs when many copper crystal grains of which the length LV is greater than 400 µm exist. It is favorable for the length LV to be not more than 400 µm.

As described above, it is favorable for at least one of the average of the distances LH or the average of the lengths LV of the copper crystal grains of the copper circuit interior to be not more than 300 µm. It is more favorable for both of the average of the distances LH and the average of the lengths LV to be not more than 300 µm. Furthermore, it is favorable for each of the distances LH and each of the lengths LV to be not more than 400 µm. In such a case, it is favorable for each of the distances LH to be not less than 50 µm. It is favorable for each of the lengths LV to be not less than 50 µm. More favorably, each of the distances LH is not less than 50 µm, and each of the lengths LV is not less than 50 µm.

Also, it is favorable for each of the distances LH to be not more than 300 µm. It is favorable for each of the lengths LV to be not more than 300 µm. More favorably, each of the distances LH is not more than 300 µm, and each of the lengths LV is not more than 300 µm. In such a case, it is favorable for each of the distances LH to be not less than 70 µm. It is favorable for each of the lengths LV to be not less than 70 µm. More favorably, each of the distances LH is not less than 70 µm, and each of the lengths LV is not less than 70 µm.

In the ceramic copper circuit board according to the embodiment, when an arbitrary straight line is drawn along the first direction in the cross section of the copper circuit part 3, the distances LH and the lengths LV of the multiple copper crystal grains crossing the straight line are within the ranges described above. In other words, the distances LH and the lengths LV are within the ranges described above when a straight line is drawn in any portion of the cross section of the copper circuit part 3. Excellent reliability can be obtained by forming a circuit of the copper circuit part 3 on the ceramic substrate.

In the case where the copper circuit part is formed by patterning a copper plate, the distance LH and the length LV may be adjusted by adjusting the crystal size in a rolling process that adjusts the thickness of the copper plate. It is also possible to adjust the crystal size by adding a trace element into the copper plate. In such a case, it is also possible to pre-add a trace element that controls the grain growth of tin (Sn), zirconium (Zr), etc., in the copper plate. It is also possible to diffuse into the copper plate an element that suppresses the grain growth in the copper plate in a process such as bonding, etc., when manufacturing the ceramic copper circuit board. Furthermore, a heat treatment process may be utilized in the manufacturing processes of the ceramic copper circuit board. The recrystallization temperature of copper is about 220 °C. As described below, active metal bonding of the copper plate to the ceramic substrate is performed. In active metal bonding, the ceramic substrate and the copper plate are heated at 700 to 900 °C. In this process, the copper plate is recrystallized. Copper crystal grains grow due to the recrystallization. The size of the copper crystal grain also can be adjusted by controlling this phenomenon.

Also, it is favorable for the thickness in the first direction of the copper circuit part to be not less than 0.5 mm, and more favorably not less than 0.8 mm. By setting the thickness of the copper circuit part to be the value described above, a greater effect of making a finer pattern when etching can be obtained. In other words, the effects of the invention are obtained even when the thickness of the copper circuit part is less than the value described above. However, the difference between a product manufactured by a conventional formation method is not large; therefore, the effects according to the inventions are not easily obtained.

The thickness of the ceramic substrate is not particularly limited. The heat dissipation is improved by making the ceramic circuit board thin and by making the copper circuit part thick. Although not particularly limited, it is favorable for the upper limit of the thickness of the copper circuit part to be not more than 5 mm. When the thickness of the copper circuit part is greater than 5 mm, the warp becomes large when bonding by active metal bonding. Thereby, there is a possibility that it may be difficult to make the ceramic substrate thin.

Also, it is favorable for the ceramic substrate 2 and the copper circuit part 3 to be bonded via the bonding layer 4. Also, when the back copper plate 5 is provided, it is favorable for the back copper plate 5 to be bonded to the ceramic substrate 2 via a bonding layer. Also, it is favorable to provide a bonding layer that includes Ag (silver) and Ti (titanium) between the ceramic substrate and the copper circuit part. The bonding layer that includes Ag and Ti is formed using an active metal brazing material. Ti is an active metal. Other than Ti, Zr (zirconium) is an example of an active metal. Mixtures of Ti, Ag, and Cu (copper) are examples of active metal brazing materials. For example, the Ti content is 0.1 to 10 wt%, the Cu content is 10 to 60 wt%, and the remainder is Ag. Also, when controlling the grain size in the copper circuit part by diffusion of the brazing material when bonding, 1 to 15 wt% of at least one type selected from the group consisting of In (indium), Sn (tin), Al (aluminum), Si (silicon), C (carbon), and Mg (magnesium) may be added as necessary. In active metal bonding that uses an active metal brazing material, an active metal brazing material paste is coated onto the ceramic substrate surface; and the copper plate is disposed on the active metal brazing material paste. This is bonded by heating at 700 to 900 °C. According to the active metal bonding, the bonding strength of the ceramic substrate and the copper circuit part can be not less than 16 kN/m.

Also, a metal thin film that has one type selected from the group consisting of Ni (nickel), Ag (silver), and Au (gold) as a major component may be provided at the copper circuit surface. A plating film, a sputtered film, etc., are examples of these metal thin films. By providing the metal thin film, the corrosion resistance, the solder wettability, etc., can be improved.

Such a ceramic copper circuit board is favorable in a semiconductor device in which a semiconductor element is mounted to a copper circuit part via a bonding layer.

FIG. 5 shows an example of a semiconductor device. In FIG. 5, 1 is a ceramic copper circuit board. 16 is a semiconductor device. 17 is a semiconductor element. 18 is a bonding layer (an example of a second bonding layer). 19 is wire bonding. 20 is a metal terminal. In FIG. 5, the semiconductor element 17 is bonded on the copper circuit part of the ceramic copper circuit board 1 via the bonding layer 18. Similarly, the metal terminal 20 is bonded via the bonding layer 18. The copper circuit part and the semiconductor element of the copper circuit part that are adjacent to each other conduct via the wire bonding 19. The semiconductor device according to the embodiment is not limited to such a structure. For example, one of the wire bonding 19 or the metal terminal 20 may be provided. Also, pluralities of the semiconductor element 17, the wire bonding 19, and the metal terminal 20 may be provided on the copper circuit part 3. Also, the semiconductor element, the wire bonding, or the metal terminal 20 may be bonded to the back copper plate 5 as necessary. Also, various configurations such as a leadframe configuration, a protruding configuration, etc., are applicable to the metal terminal 20.

Also, the bonding layer 18 that bonds the semiconductor element 17 and/or the metal terminal 20 includes solder, a brazing material, etc. Lead-free solder is favorable as the solder. Also, solder refers to solder that has a melting point that is not more than 450 °C. The brazing material refers to a brazing material that has a melting point that is greater than 450 °C. Also, a brazing material that has a melting point that is not less than 500 °C is called a high-temperature brazing material. A brazing material that has Ag as a major component is an example of a high-temperature brazing material.

The ceramic copper circuit board according to the embodiment has excellent etching characteristics in the circuit formation because the average of the distances LH is set to be not more than 300 µm. In particular, it is possible to obtain the fine pattern formation effect due to the suppression of the side etching characteristics as the thickness of the copper circuit board reaches or exceeds 0.8 mm and the copper plate becomes thick. When the copper plate becomes thick and fine pattern formation is difficult, there are cases where pattern defects occur due to etching residue. Also, it is necessary to take measures such as reducing the etching rate for side etching prevention. From this perspective, according to the embodiment, the reliability of the ceramic copper circuit board can be increased, and the cost performance can be improved.

The ceramic copper circuit board according to the embodiment can relax stress because the average of the lengths LV is set to be not more than 300 µm. Residual stress of the bond between the copper plate and the ceramic is generated in the ceramic copper circuit board. Furthermore, normally, a semiconductor element is mounted on the copper circuit; therefore, stress is generated by the thermal expansion difference of the ceramic substrate and the copper circuit by heat generation from the semiconductor element. The stress that is generated in the copper circuit part decreases as the grain size of the copper circuit part in a direction perpendicular to the bonding surface with the ceramic substrate decreases. When the stress decreases, it is possible to suppress the occurrence of cracks, etc., due to the stress difference between the ceramic substrate and the copper circuit part even when the thickness of the copper circuit part is thick, i.e., not less than 0.5 mm.

From this perspective, according to the embodiment, the reliability of the ceramic copper circuit board can be increased.

Also, the downsizing of semiconductor elements continues; on the other hand, the heat generation amount from the chips is increasing. Therefore, it is important to improve the heat dissipation of ceramic copper circuit boards in which semiconductor elements are mounted. Also, multiple semiconductor elements may be mounted on a ceramic copper circuit board for higher performance of the semiconductor device (the semiconductor module). Even for only one semiconductor element, if the intrinsic temperature of the element is undesirably exceeded, the temperature coefficient undesirably changes to a temperature coefficient on the negative side in which the resistance is negative. Accordingly, a phenomenon occurs in which thermal runaway occurs in which concentrated electrical power flows, and breakdown of the semiconductor device instantaneously occurs. Therefore, it is extremely effective to increase the reliability of the bond between the semiconductor element and the copper circuit part. Also, the semiconductor device according to the embodiment can be used in PCU, IGBT, and IPM modules used in inverters of automobiles (including electric vehicles), electric railway vehicles, industrial machinery, air conditioners, etc. For automobiles, electric vehicles are becoming widespread. The safety of automobiles can be increased by increasing the reliability of the semiconductor devices. This is similar for electric railway vehicles, industrial devices, etc., as well.

A method for manufacturing the ceramic copper circuit board according to the embodiment will now be described. The manufacturing method is not particularly limited as long as the ceramic copper circuit board has a configuration described above. Here, an example of a method for obtaining a ceramic copper circuit board with a high yield is illustrated.

First, a ceramic substrate and a copper plate are prepared. The thickness of the copper plate is not less than 0.5 mm.

Also, one type selected from an aluminum oxide substrate, an aluminum nitride substrate, and a silicon nitride substrate is favorable as the ceramic substrate. In particular, when considering the heat dissipation of the entire circuit board, it is favorable for the ceramic substrate to be a silicon nitride substrate that has a thermal conductivity that is not less than 50 W/(m·K) and a three-point bending strength that is not less than 600 MPa.

Also, in the case where the copper circuit part located at the front surface of the ceramic substrate and the back copper plate located at the back surface conduct via a through-hole, a ceramic substrate that includes a through-hole is prepared when a through-hole is provided in the ceramic substrate, the through-hole may be provided beforehand in the formed body stage. Also, a through-hole may be provided in the ceramic substrate (the ceramic sintered body). The through-hole is provided by laser patterning, cutting, etc. Boring such as drilling, etc., are examples of cutting.

It is favorable to prepare the copper plate so that the average of the distances LH of the copper crystal grains of the interior is not more than 300 µm when heating at the bonding conditions to the ceramic. Furthermore, it is favorable to prepare the copper plate so that each of the distances LH is not more than 400 µm. It is favorable for each of the distances LH to be not less than 50 µm, and more favorably not less than 70 µm.

Also, it is favorable to prepare the copper plate so that the average of the lengths LV of the copper crystal grains of the interior is not more than 300 µm when heating at the bonding conditions to the ceramic. Furthermore, it is favorable to prepare the copper plate so that each of the lengths LV is not more than 400 µm. It is favorable for each of the lengths LV to be not less than 50 µm, and more favorably not less than 70 µm.

When the ceramic substrate and the copper plate are bonded by active metal bonding, the bonding temperature is about 700 to 900 °C. When the copper plate is exposed to such temperatures, the copper recrystallizes; therefore, the crystal grains become large. Compared to the ranges described above, it is favorable to use a copper plate that includes copper crystal grains having shorter distances LH and shorter lengths LV so that the distances LH and the lengths LV of the copper crystal grains become within the ranges described above.

Also, it is favorable for the ceramic substrate and the copper plate to be bonded by active metal bonding. In active metal bonding, an active metal brazing material in which Ag and an active metal such as Ti, etc., are mixed is used. Mixtures of Ti, Ag, and Cu are examples of the active metal brazing material. In the active metal brazing material, the Ti content is 0.1 to 10 wt%, the Cu content is 10 to 60 wt%, and the remainder is Ag. Also, at least one type selected from the group consisting of In, Sn, Al, Si, C, and Mg may be added within the range of 1 to 15 wt% as necessary.

The active metal brazing material is formed as a paste. A brazing material component and an organic substance are mixed in the paste. It is favorable for the brazing material component to be uniformly mixed in the paste. This is because when the brazing material component is nonuniformly distributed, the brazing is not stable, which causes bonding defects.

There are various methods for uniformly dispersing the brazing material. A general method of mixing a powder can be used such as dry or wet milling, mixing with an agitator, pulverizing a pre-formed alloy, etc.

The copper crystal grain is made larger by the brazing material diffusing in the copper plate interior when brazing. Therefore, it is favorable to prepare the brazing material not to diffuse into the copper plate interior when manufacturing the brazing material. Among the brazing material components described above, the combination of Ag and at least one selected from the group consisting of In and Sn is a component that suppresses the diffusion. Therefore, the elements that are included in the combination are mixed to be uniform in the paste. The mixing may be performed for a sufficient amount of time to make the brazing material components uniform, or a process for premixing the combination described above may be added.

The active metal brazing material paste that is thus manufactured is coated onto the ceramic substrate. The copper plate is disposed on the paste. Then, the ceramic substrate on which the copper plate is disposed is bonded by heating at 700 to 900 °C. The heating process is performed in a vacuum or in a nonoxidizing atmosphere as necessary. Also, when performed in a vacuum, it is favorable to be not more than 1×10⁻² Pa. A nitrogen atmosphere, an argon atmosphere, etc., are examples of the nonoxidizing atmosphere.

By using a vacuum or a nonoxidizing atmosphere, the oxidization of the bonding layer can be suppressed. An increase of the bonding strength is realized thereby. Also, the diffusion of the brazing material in the copper plate can be adjusted by adjusting the bonding temperature and/or the time.

To control the diffusion state of the brazing material component in the copper plate, it is favorable to perform a degreasing process of the active metal brazing material paste in a thermal bonding process. In the thermal bonding process, the bonding temperature is maintained within the range of 700 to 900 °C. The diffusion amount of the brazing material component into the copper plate can be controlled by degreasing the organic substances in the paste before the temperature reaches this range. This is because the brazing material that contacts the copper plate can be homogenized by degreasing the organic substances in the brazing material paste before bonding.

In the degreasing process of the brazing material paste, for example, the temperature is maintained within the range of 250 to 500 °C. The holding time is within the range of 5 to 60 minutes. Also, as another method, it is also effective to set the heating rate toward the bonding temperature to be not more than 10 °C/minute.

Also, the copper plate to be bonded may be pre-patterned into a patterned configuration or may be a continuous plate. When a continuous plate is used, patterning by etching is performed after bonding to pattern the continuous plate into a patterned configuration.

By this process, the ceramic copper circuit board can be manufactured. Then, a process of bonding a semiconductor element, etc., to the ceramic copper circuit board is performed. A bonding layer is provided at the location where the semiconductor element will be bonded. It is favorable for the bonding layer to include solder or a brazing material. The bonding layer is provided; and the semiconductor element is provided on the bonding layer. Also, a metal terminal is bonded via the bonding layer as necessary. Also, wire bonding is provided as necessary. Also, the necessary number of semiconductor elements, metal terminals, and wire bonding are provided.

### (Example)

### (Examples 1 to 22 and comparative examples 1 to 9)

A silicon nitride substrate, an aluminum nitride substrate, and an aluminum oxide (alumina) substrate were prepared as the ceramic substrate. The thermal conductivity of the silicon nitride substrate is 90 W/(m·K); and the three-point bending strength is 650 MP. The thermal conductivity of the aluminum nitride substrate is 170 W/(m·K); and the three-point bending strength is 300 MPa. The thermal conductivity of the aluminum oxide substrate is 20 W/(m·K); and the three-point bending strength is 350 MPa. The size of the ceramic substrate is 50 mm long×40 mm wide. The thickness of the silicon nitride substrate is 0.32 mm. The thickness of the aluminum nitride substrate and the thickness of the alumina substrate are 0.635 mm.

Then, the copper plates shown in Table 1 were prepared. Copper plates that were 40 mm long×30 mm wide were cut out from base materials and used as measurement test copper plates for measuring the grain boundary horizontal distance and the grain boundary vertical distance after heating. The measurement test plate was cut in the lateral direction to have a length of 30 mm wide after heating in a nitrogen atmosphere at 600 °C for 1 hour. The central portion vicinity (a position of about 15 mm from the end portion) of the cut test plate was observed at a magnification of 20 times using a scanning electron microscope (SEM: Scanning Electron Microscope); and a photograph was imaged. For the measurement position in the thickness direction, the entirety from the back surface to the front surface was measured for the copper plates 1 to 9 having a thickness of 0.5 mm. For the copper plates 10 to 18 having a thickness of 0.8 mm, the end portion vicinity in the thickness direction (up to locations about 150 µm from the upper and lower surfaces) was measured.

The distance LH and the length LV of the copper crystal grain of the copper plate were calculated by the following procedure. First, an arbitrary straight line parallel to the first direction is drawn in the observed region. Then, five copper crystal grains that cross the straight line are extracted. The five copper crystal grains were randomly extracted. However, crystal grains that were partially cut off at the edge of the observation region were excluded. The distance LH in the second direction between the arbitrary straight line and the outer edge of the copper crystal grain was measured for each of the five copper crystal grains; and the average value of the distances LH are shown in Table 1 as the distance LH. Also, the length LV in the first direction between the intersections between the arbitrary straight line and the outer edge of the copper crystal grain was measured for each of the five copper crystal grains; and the average value of the lengths LV is shown in Table 1 as the length LV.

**[Table 1]**

| | COPPER PLATE THICKNESS (mm) | DISTANCE LH (µm) | LENGTH LV (µm) |
|---|---|---|---|
| COPPER PLATE 1 | 0.5 | 159 | 154 |
| COPPER PLATE 2 | 0.5 | 143 | 253 |
| COPPER PLATE 3 | 0.5 | 153 | 347 |
| COPPER PLATE 4 | 0.5 | 159 | 153 |
| COPPER PLATE 5 | 0.5 | 250 | 256 |
| COPPER PLATE 6 | 0.5 | 150 | 346 |
| COPPER PLATE 7 | 0.5 | 353 | 153 |
| COPPER PLATE 8 | 0.5 | 350 | 255 |
| COPPER PLATE 9 | 0.5 | 359 | 347 |
| COPPER PLATE 10 | 0.8 | 153 | 157 |
| COPPER PLATE 11 | 0.8 | 144 | 257 |
| COPPER PLATE 12 | 0.8 | 158 | 341 |
| COPPER PLATE 13 | 0.8 | 251 | 158 |
| COPPER PLATE 14 | 0.8 | 249 | 259 |
| COPPER PLATE 15 | 0.8 | 259 | 348 |
| COPPER PLATE 16 | 0.8 | 351 | 155 |
| COPPER PLATE 17 | 0.8 | 350 | 253 |
| COPPER PLATE 18 | 0.8 | 357 | 356 |

Then, the ceramic substrate and the copper plate were bonded by active metal bonding. The copper plate that was used had the same size as the measurement test copper plate that was cut out from the base material to be 40 mm long×30 mm wide. The active metal brazing material that was used in the active metal bonding included a Ti content of 2 wt%, a Sn content of 10 wt%, and a Cu content of 30 wt%; and the remainder was Ag.

For the active metal paste, a brazing material (normal mixing) in which the materials to be used are simultaneously mixed and a brazing material (premixing) in which the other active metal brazing material components are mixed after premixing Sn and Ag were prepared; and each brazing material was formed as a paste by mixing an organic component.

An active metal paste was coated onto the two surfaces of the ceramic substrate; copper plates were respectively disposed at the two surfaces; and a thermal bonding process was performed. Also, the bonding temperature was set to 790 to 850 °C, the bonding time was set to 5 to 20 minutes, and bonding was performed in a vacuum (not more than 1×10⁻² Pa). The grain growth of the copper crystal grains of the copper plate interior was controlled by changing the bonding temperature and the bonding time.

Also, the copper plate of the front surface (the front copper plate) was made into a circuit configuration by patterning by etching. The copper plate (the back copper plate) of the back surface also was etching-patterned into circuit configurations by patterning the front copper plate into one of two to four circuit configurations. In the fine pattern formation of the front copper plate, the pattern dimension was set to 0.5 mm. For the front copper plates having the thickness of 0.5 mm, etching was performed by setting the inter-pattern dimension to be 0.8 mm when the side etching amount and the jutting amount of the brazing material were taken to be zero. For the front copper plates having the thickness of 0.8 mm, etching was performed by setting the inter-pattern dimension to be 1.1 mm when the side etching amount and the jutting amount of the brazing material were taken to be zero. The front copper plates having the thickness of 0.5 mm and the front copper plates having the thickness of 0.8 mm were etched using the same conditions.

For these manufacturing conditions, the paste for which the premixing is performed can suppress the growth of the copper crystal grains by making the dispersion more uniform than the paste for which the normal mixing is performed. However, the premixing adds a process to the normal mixing. Therefore, compared to the normal mixing, the cost performance degrades when the premixing is used.

Also, within the bonding temperature of 790 to 850 °C, a lower bonding temperature can suppress the growth of the copper crystal grains. However, when the lower limit of the bondable temperature is approached, there is a possibility that delamination may easily occur or the bonding strength may decrease.

Also, within the bonding time of 5 to 20 minutes, a shorter bonding time can suppress the grain growth of copper. However, as the bonding time decreases, the likelihood of the brazing material not being able to sufficiently react increases, and there is a possibility that the bonding strength may decrease.

Therefore, according to the examples 1 to 22, based on the distance LH and the length LV measured in Table 1, the normal manufacturing conditions (the normal mixing paste, a bonding temperature of 830 °C, and a bonding time of 10 minutes) were used when the distance LH and the length LV were small. Manufacturing conditions that suppress the grain growth of the copper crystal grains (the premixed paste, a bonding temperature of 790 °C, and a bonding time of 5 minutes) were used when the distance LH and the length LV were large.

Conversely, for the comparative examples 1 to 3, the normal manufacturing conditions (the normal mixing paste, a bonding temperature of 830 °C, and a bonding time of 10 minutes) were used when the distance LH and the length LV measured in Table 1 were large. For the comparative examples 4 to 5, manufacturing conditions that suppress the grain growth of the copper crystal grains (the premixed paste, a bonding temperature of 790 °C, and a bonding time of 5 minutes) were used when the distance LH and the length LV measured in Table 1 were even larger. For the comparative examples 6 to 9, manufacturing conditions that further promote the grain growth of the copper crystals (a bonding temperature of 850 °C and a bonding time of 20 minutes) were used.

The ceramic copper circuit boards that were obtained are shown in Table 2.

**[Table 2]**

| | COPPER PLATE | SUBSTRATE | PASTE | BONDING TEMPERATURE (°C) | BONDING TIME (min) |
|---|---|---|---|---|---|
| EXAMPLE 1 | COPPER PLATE 1 | SILICON NITRIDE | NORMAL MIXING | 830 | 10 |
| EXAMPLE 2 | COPPER PLATE 2 | SILICON NITRIDE | NORMAL MIXING | 830 | 10 |
| EXAMPLE 3 | COPPER PLATE 3 | SILICON NITRIDE | NORMAL MIXING | 830 | 10 |
| EXAMPLE 4 | COPPER PLATE 4 | SILICON NITRIDE | NORMAL MIXING | 830 | 10 |
| EXAMPLE 5 | COPPER PLATE 5 | SILICON NITRIDE | NORMAL MIXING | 790 | 10 |
| EXAMPLE 6 | COPPER PLATE 5 | ALUMINUM NITRIDE | NORMAL MIXING | 830 | 5 |
| EXAMPLE 7 | COPPER PLATE 5 | ALUMINA | PREMIXING | 830 | 10 |
| EXAMPLE 8 | COPPER PLATE 6 | SILICON NITRIDE | NORMAL MIXING | 790 | 10 |
| EXAMPLE 9 | COPPER PLATE 6 | ALUMINUM NITRIDE | NORMAL MIXING | 830 | 5 |
| EXAMPLE 10 | COPPER PLATE 6 | ALUMINA | PREMIXING | 830 | 10 |
| EXAMPLE 11 | COPPER PLATE 7 | SILICON NITRIDE | NORMAL M XING | 830 | 10 |
| EXAMPLE 12 | COPPER PLATE 8 | SILICON NITRIDE | NORMAL M XING | 790 | 10 |
| EXAMPLE 13 | COPPER PLATE 8 | ALUMINUM NITRIDE | NORMAL MIXING | 830 | 5 |
| EXAMPLE 14 | COPPER PLATE 8 | ALUMINA | PREMIXING | 830 | 10 |
| EXAMPLE 15 | COPPER PLATE 10 | SILICON NITRIDE | NORMAL MIXING | 830 | 10 |
| EXAMPLE 16 | COPPER PLATE 11 | SILICON NITRIDE | NORMAL MIXING | 830 | 10 |
| EXAMPLE 17 | COPPER PLATE 12 | SILICON NITRIDE | NORMAL MIXING | 830 | 10 |
| EXAMPLE 18 | COPPER PLATE 13 | SILICON NITRIDE | NORMAL M XING | 830 | 10 |
| EXAMPLE 19 | COPPER PLATE 14 | SILICON NITRIDE | NORMAL MIXING | 790 | 5 |
| EXAMPLE 20 | COPPER PLATE 15 | SILICON NITRIDE | PREMIXING | 830 | 10 |
| EXAMPLE 21 | COPPER PLATE 16 | SILICON NITRIDE | NORMAL MIXING | 790 | 10 |
| EXAMPLE 22 | COPPER PLATE 17 | SILICON NITRIDE | NORMAL MIXING | 830 | 5 |
| COMPARATIVE EXAMPLE 1 | COPPER PLATE 5 | SILICON NITRIDE | NORMAL MIXING | 830 | 10 |
| COMPARATIVE EXAMPLE 2 | COPPER PLATE 6 | SILICON NITRIDE | NORMAL MIXING | 830 | 10 |
| COMPARATIVE EXAMPLE 3 | COPPER PLATE 8 | ALUMINUM NITRIDE | NORMAL MIXING | 830 | 10 |
| COMPARATIVE EXAMPLE 4 | COPPER PLATE 9 | ALUMINA | PREMIXING | 790 | 5 |
| COMPARATIVE EXAMPLE 5 | COPPER PLATE 18 | SILICON NITRIDE | PREMIXING | 790 | 5 |
| COMPARATIVE EXAMPLE 6 | COPPER PLATE 9 | ALUMINUM NITRIDE | NORMAL MIXING | 850 | 10 |
| COMPARATIVE EXAMPLE 7 | COPPER PLATE 18 | SILICON NITRIDE | NORMAL MIXING | 850 | 10 |
| COMPARATIVE EXAMPLE 8 | COPPER PLATE 9 | ALUMINA | NORMAL MIXING | 790 | 20 |
| COMPARATIVE EXAMPLE 9 | COPPER PLATE 18 | SILICON NITRIDE | NORMAL MIXING | 790 | 20 |

Then, the distance LH and the length LV were measured for the obtained samples by observing the cross-sectional structure using SEM. Distances LH1 to LH4 and lengths LV1 to LV4 were determined based on the measured distance LH and length LV. The distance LH1 is the maximum value of the multiple distances LH. The distance LH2 is the average value of the multiple distances LH. The distance LH3 is the minimum value of the multiple distances LH. The distance LH4 is the difference between the maximum value (*LH1*) and the minimum value (*LH3*). The length LV1 is the maximum value of the multiple lengths LV. The length LV2 is the average value of the multiple lengths LV. The length LV3 is the minimum value of the multiple lengths LV. The length LV4 is the difference between the maximum value (*LV1*) and the minimum value (*LV3*).

The results are shown in Table 3.

**[Table 3]**

| | LH1 MAXIMUM VALUE (µm) | LH2 AVERAGE VALUE (µm) | LH3 MINIMUM VALUE (µm) | LH4 DIFFERENCE (µm) | LV1 MAXIMUM VALUE (µm) | LV2 AVERAGE VALUE (µm) | LV3 MINIMUM VALUE (µm) | LV4 DIFFERENCE (µm) |
|---|---|---|---|---|---|---|---|---|
| EXAMPLE 1 | 312 | 219 | 118 | 194 | 311 | 217 | 112 | 199 |
| EXAMPLE 2 | 316 | 211 | 116 | 200 | 411 | 312 | 215 | 196 |
| EXAMPLE 3 | 307 | 208 | 108 | 199 | 507 | 399 | 293 | 214 |
| EXAMPLE 4 | 414 | 310 | 210 | 204 | 318 | 212 | 112 | 206 |
| EXAMPLE 5 | 390 | 296 | 190 | 200 | 395 | 295 | 198 | 197 |
| EXAMPLE 6 | 386 | 284 | 181 | 205 | 487 | 384 | 287 | 200 |
| EXAMPLE 7 | 565 | 401 | 304 | 261 | 311 | 217 | 112 | 199 |
| EXAMPLE 8 | 499 | 395 | 29 | 206 | 394 | 294 | 194 | 200 |
| EXAMPLE 9 | 482 | 384 | 285 | 197 | 386 | 288 | 185 | 201 |
| EXAMPLE 10 | 490 | 396 | 291 | 199 | 399 | 296 | 199 | 200 |
| EXAMPLE 11 | 512 | 401 | 306 | 206 | 310 | 211 | 118 | 192 |
| EXAMPLE 12 | 489 | 383 | 284 | 205 | 388 | 281 | 184 | 204 |
| EXAMPLE 13 | 492 | 390 | 297 | 195 | 395 | 293 | 198 | 197 |
| EXAMPLE 14 | 495 | 397 | 295 | 200 | 399 | 295 | 191 | 208 |
| EXAMPLE 15 | 310 | 208 | 106 | 204 | 309 | 206 | 104 | 205 |
| EXAMPLE 16 | 311 | 211 | 114 | 197 | 411 | 311 | 212 | 199 |
| EXAMPLE 17 | 315 | 210 | 115 | 200 | 512 | 400 | 301 | 211 |
| EXAMPLE 18 | 405 | 302 | 201 | 204 | 301 | 208 | 101 | 200 |
| EXAMPLE 19 | 373 | 273 | 178 | 195 | 377 | 275 | 173 | 204 |
| EXAMPLE 20 | 373 | 276 | 173 | 200 | 475 | 371 | 276 | 199 |
| EXAMPLE 21 | 483 | 389 | 284 | 199 | 388 | 285 | 189 | 199 |
| EXAMPLE 22 | 494 | 390 | 291 | 203 | 391 | 290 | 190 | 201 |
| COMPARATIVE EXAMPLE 1 | 414 | 318 | 218 | 196 | 414 | 317 | 214 | 200 |
| COMPARATIVE EXAMPLE 2 | 408 | 301 | 206 | 202 | 507 | 410 | 301 | 206 |
| COMPARATIVE EXAMPLE 3 | 514 | 419 | 311 | 203 | 415 | 310 | 217 | 198 |
| COMPARATIVE EXAMPLE 4 | 450 | 351 | 256 | 194 | 457 | 351 | 257 | 200 |
| COMPARATIVE EXAMPLE 5 | 509 | 406 | 302 | 207 | 507 | 408 | 304 | 203 |
| COMPARATIVE EXAMPLE 6 | 606 | 452 | 311 | 295 | 605 | 459 | 319 | 286 |
| COMPARATIVE EXAMPLE 7 | 605 | 458 | 318 | 287 | 608 | 452 | 313 | 295 |
| COMPARATIVE EXAMPLE 8 | 549 | 446 | 344 | 205 | 550 | 450 | 344 | 206 |
| COMPARATIVE EXAMPLE 9 | 550 | 453 | 354 | 196 | 550 | 452 | 357 | 193 |

It can be seen from the table that the distance LH1 and the length LV1 were within the range of the favorable embodiment for the ceramic copper circuit boards according to the examples. On the other hand, for the comparative examples, the distance LH1 and the length LV1 were large compared to the examples.

Then, the amount of the side etching was checked for the ceramic copper circuit boards according to the examples and the comparative examples. The horizontal distances of the front surface and the back surface of the copper circuit part were measured using an optical microscope; and the most distant distance was set to the side etching amount.

Also, the inter-pattern dimension was measured using a projector. The distance between the location of the bonding layer at which the side etching amount described above was measured and the other bonding layer adjacent to the location was measured as the inter-pattern dimension.

Also, the peel strength was measured as the bonding strength between the copper circuit part and the ceramic substrate. The peel strength was measured by peeling a copper circuit part pre-formed to have a width of 3 mm at 50 mm/minute along the first direction. Also, the bonding strength of the ceramic circuit board was measured by pressing the ceramic circuit board from the vertical direction using a three-point bending jig.

Then, the reliability was evaluated for the ceramic copper circuit boards according to the examples and the comparative examples. The bondability of the semiconductor element was evaluated as the reliability.

In the evaluation, instead of using samples after being cut for the copper crystal grain size measurement or samples after measuring the bonding strength and/or the three-point bending strength, samples that were made using the same conditions as the examples and the comparative examples were used for evaluating the reliability.

For the bondability of the semiconductor element, the semiconductor element and the metal terminal were bonded using lead-free solder. Furthermore, wire bonding was provided, and the semiconductor element and the metal terminal were caused to conduct. The semiconductor device was made thereby. Then, the occurrence rate of conduction defects was checked by performing a temperature cycle test (TCT) for the semiconductor devices. In the TCT, the delamination area due to cracks was calculated using ultrasonic flaw detection (SAT: Scanning Acoustic Tomograph) after 300 cycles in which one cycle was -40 °C×30 minutes → room temperature×10 minutes → 150 °C×30 minutes → room temperature×10 minutes. Then, a non-delamination area ratio η was evaluated. The non-delamination area ratio η when there was absolutely no occurrence of cracks in the TCT was taken as *η* = 100%; and the non-delamination area ratio η when cracks occurred in the entire bonding portion surface of the ceramic copper circuit board in the TCT was taken as *η* = 0%.

The measurement results are shown in Table 4.

**[Table 4]**

| | SIDE ETCHING AMOUNT (mm) | INTER-PATTERN DIMENSION (mm) | BONDING STRENGTH (kN/m) | THREE-POINT BENDING STRENGTH (MPa) | NON-DELAMINATION AREA RATIO η(%) |
|---|---|---|---|---|---|
| EXAMPLE 1 | 0.10 | 0.55 | 28 | 709 | 100 |
| EXAMPLE 2 | 0.12 | 0.51 | 20 | 502 | 100 |
| EXAMPLE 3 | 0. 13 | 0.49 | 16 | 420 | 100 |
| EXAMPLE 4 | 0.15 | 0.46 | 28 | 710 | 100 |
| EXAMPLE 5 | 0.18 | 0.39 | 24 | 624 | 100 |
| EXAMPLE 6 | 0.18 | 0.39 | 17 | 205 | 100 |
| EXAMPLE 7 | 0.25 | 0.26 | 28 | 407 | 100 |
| EXAMPLE 8 | 0.25 | 0.25 | 24 | 620 | 100 |
| EXAMPLE 9 | 0.25 | 0.26 | 24 | 259 | 100 |
| EXAMPLE 10 | 0.25 | 0.26 | 24 | 312 | 100 |
| EXAMPLE 11 | 0.30 | 0.15 | 28 | 703 | 100 |
| EXAMPLE 12 | 0.25 | 0.26 | 24 | 618 | 100 |
| EXAMPLE 13 | 0.25 | 0.26 | 24 | 265 | 100 |
| EXAMPLE 14 | 0.25 | 0.25 | 24 | 318 | 100 |
| EXAMPLE 15 | 0.12 | 0.82 | 28 | 708 | 100 |
| EXAMPLE 16 | 0.12 | 0.82 | 20 | 501 | 100 |
| EXAMPLE 17 | 0.12 | 0.81 | 16 | 402 | 100 |
| EXAMPLE 18 | 0.30 | 0.45 | 28 | 711 | 100 |
| EXAMPLE 19 | 0.18 | 0.69 | 24 | 609 | 100 |
| EXAMPLE 20 | 0.18 | 0.69 | 18 | 466 | 100 |
| EXAMPLE 21 | 0.40 | 0.26 | 24 | 617 | 100 |
| EXAMPLE 22 | 0.40 | 0.25 | 24 | 608 | 100 |
| COMPARATIVE EXAMPLE 1 | 0.20 | 0.36 | 20 | 510 | 100 |
| COMPARATIVE EXAMPLE 2 | 0.20 | 0.34 | 15 | 359 | 95 |
| COMPARATIVE EXAMPLE 3 | 0.30 | 0.15 | 20 | 261 | 100 |
| COMPARATIVE EXAMPLE 4 | 0.25 | 0.24 | 19 | 270 | 100 |
| COMPARATIVE EXAMPLE 5 | 0.50 | 0.05 | 14 | 355 | 80 |
| COMPARATIVE EXAMPLE 6 | 0.50 | SHORT | 13 | 153 | 90 |
| COMPARATIVE EXAMPLE 7 | 0.60 | SHORT | 12 | 257 | 70 |
| COMPARATIVE EXAMPLE 8 | 0.50 | SHORT | 13 | 199 | 85 |
| COMPARATIVE EXAMPLE 9 | 0.60 | SHORT | 12 | 263 | 60 |

Among the ceramic copper circuit boards according to the examples, when both of the distance LH2 and the length LV2 satisfied being not more than 300 µm, the side etching amount was less than 0.10 mm when the copper plate thickness was 0.5 mm. The side etching amount was less than 0.20 mm when the copper plate thickness was 0.8 mm. The inter-pattern dimension increased as the side etching amount decreases. In other words, in the ceramic copper circuit boards according to the examples, even for the same etching conditions as the comparative examples, the inter-pattern dimension can be reduced, and a fine pattern can be formed. Also, due to the effects of the stress relaxation of the copper circuit part, the bonding strength was not less than 24 kN/m. For the silicon nitride substrate, the three-point bending strength was 600 MPa. For the aluminum nitride substrate, the three-point bending strength was 250 MPa. For the alumina substrate, the three-point bending strength was not less than 300 MPa. Thus, according to the examples, a highly-reliable ceramic copper circuit board was obtained.

Also, among the ceramic copper circuit boards according to the examples, when only one of the distance LH2 or the length LV2 was not more than 300 µm, a ceramic copper circuit board that had good side etching amount or a ceramic copper circuit board that had good bonding strength and the three-point bending strength due to the stress relaxation were respectively obtained.

Good results were obtained when each of the distance LH1 and the length LV1 satisfied being not more than 300 µm.

Good results were obtained when each of the distance LH3 and the length LV3 satisfied being not more than 200 µm.

Good results were obtained when each of the distance LH4 and the length LV4 satisfied being not more than 220 µm.

Conversely, for the comparative examples, the side etching amount was large, a state in which the region between the pattern was not formed (a short) occurred, and the bonding strength and/or the three-point bending strength were low. It can be seen from this result that the distance LH and the length LV affect the side etching amount, the bonding strength, and the three-point bending strength.

Also, a difference of the non-delamination area ratio η occurred between the examples and the comparative examples. This is because the side etching amount, the bonding strength, and the three-point bending strength were increased by controlling the distance LH1 of the copper circuit interior and the length LV1 according to the examples.

Conversely, cases where the non-delamination area ratio η degraded existed in the comparative examples. This is because the distance LH2 and the length LV2 of the copper crystal grain were large and the side etching amount was large for the copper circuit part. Also, this is because the load on the bonding portion was large because the bonding strength and the three-point bending strength were decreased and the thermal stress of the ceramic copper circuit board interior increased.

Although several embodiments of the invention are illustrated hereinabove, these embodiments have been presented by way of example only, and are not intended to limit the scope of the inventions. These novel embodiments may be embodied in a variety of other forms; furthermore, various omissions, substitutions, modifications, etc., can be made without departing from the spirit of the inventions. These embodiments and their modifications are included in the scope and spirit of the inventions and are within the scope of the inventions described in the claims and their equivalents. Also, embodiments described above can be implemented in combination with each other.

### [Reference Numeral List]

- 1: ceramic copper circuit board
- 2: ceramic substrate
- 3: copper circuit part (front copper plate)
- 4: bonding layer (brazing material)
- 5: copper circuit part (back copper plate)
- 6: copper circuit cross-sectional view (portion A enlarged view)
- 7: line drawn arbitrarily perpendicular to thickness direction of substrate
- 8: side etching amount
- 9: copper plate interior cross-sectional view (portion B enlargement)
- 10: copper crystal grain
- 11: grain boundary of copper crystal grain
- 12: distance (LH)
- 13: length (LV)
- 14: pattern dimension
- 15: inter-pattern dimension
- 16: semiconductor device
- 17: semiconductor element
- 18: bonding layer
- 19: wire bonding
- 20: metal terminal

## Claims

1. A ceramic copper circuit board (1), comprising:
a ceramic substrate (2); and
a copper circuit part (3) located on the ceramic substrate (2),
an arbitrary line drawn along a first direction at a cross section of the copper circuit part (3) crosses a plurality of copper crystal grains (10),
the cross section being parallel to the first direction,
the first direction being from the ceramic substrate (2) toward the copper circuit part (3),
an average of a plurality of distances in a second direction between the line and edges of the copper crystal grains (10) being not more than 300 µm,
the second direction being perpendicular to the first direction.

2. The ceramic copper circuit board (1) according to claim 1, wherein
a maximum value of the plurality of distances is not more than 400 µm.

3. The ceramic copper circuit board (1) according to any one of claims 1 to 2, wherein
a minimum value of the plurality of distances is not more than 200 µm.

4. The ceramic copper circuit board (1) according to any one of claims 1 to 3, wherein
a difference between a maximum value of the plurality of distances and a minimum value of the plurality of distances is not more than 220 µm.

5. The ceramic copper circuit board (1) according to any one of claims 1 to 4, wherein
an outer edge of each of the plurality of copper crystal grains (10) includes a first edge and a second edge crossing the line, and
an average of lengths in the first direction between the first edge and the second edge of each of the plurality of copper crystal grains (10) is not more than 300 µm.

6. The ceramic copper circuit board (1) according to claim 5, wherein
a maximum value of a plurality of the lengths is not more than 400 µm.

7. The ceramic copper circuit board (1) according to any one of claims 5 to 6, wherein
a minimum value of a plurality of the lengths is not more than 200 µm.

8. The ceramic copper circuit board (1) according to any one of claims 5 to 7, wherein
a difference between a maximum value of a plurality of the lengths and a minimum value of the plurality of lengths is not more than 220 µm.

9. The ceramic copper circuit board (1) according to any one of claims 1 to 8, wherein
the ceramic substrate (2) is at least one type of an aluminum oxide substrate, an aluminum nitride substrate, or a silicon nitride substrate.

10. The ceramic copper circuit board (1) according to any one of claims 1 to 9, wherein
a thickness in the first direction of the ceramic substrate (2) is not more than 0.7 mm.

11. The ceramic copper circuit board (1) according to any one of claims 1 to 10, further comprising:
a first bonding layer (4) located between the ceramic substrate (2) and the copper circuit part (3), and
the first bonding layer(4) including at least two selected from the group consisting of Ag, Cu, Ti, Sn, In, Zr, Al, Si, C, and Mg.

12. The ceramic copper circuit board (1) according to any one of claims 1 to 11, comprising:
a plurality of the copper circuit parts (3); and
a plurality of first bonding layers (4) located respectively between the ceramic substrate (2) and the plurality of copper circuit parts (3),
a minimum distance between adjacent first bonding layers (4) of the plurality of first bonding layers (4) being less than 1.0 mm.

13. The ceramic copper circuit board (1) according to any one of claims 1 to 12, wherein
a thickness in the first direction of the copper circuit part (3) is not less than 0.5 mm.

14. A semiconductor device (16), comprising:
the ceramic copper circuit board (1) according to any one of claims 1 to 13; and
a semiconductor element (17) mounted on the copper circuit part (3) via a second bonding layer (18).
